# EUROPÄISCHE PATENTSCHRIFT

(11) **EP 3 394 672 B1**
(45) Veröffentlichungstag und Bekanntmachung des Hinweises auf die Patenterteilung: **05.02.2020**
(21) Anmeldenummer: 16822444.2
(22) Anmeldetag: 19.12.2016
(51) Int. Cl.: G03F 7/00, G03F 7/032, G03F 7/033, G03F 7/12

(54) **VERFAHREN ZUR GENERATIVEN HERSTELLUNG VON RELIEFDRUCKFORMEN MITTELS MONOMERDIFFUSION DURCH EINE INTEGRALE MASKENSCHICHT**
METHOD FOR THE GENERATIVE PRODUCTION OF RELIEF PRINTING PLATES USING MONOMER DIFFUSION BY MEANS OF AN INTEGRAL MASK LAYER
PROCEDE DE FABRICATION GENERATIVE DE MOULES D'IMPRESSION EN RELIEF A L'AIDE DE DIFFUSION DE MONOMERE PAR UNE COUCHE DE MASQUE INTEGRALE

(30) Priorität: 21.12.2015 EP 15201476
(43) Veröffentlichungstag der Anmeldung: 31.10.2018
(73) Patentinhaber: Flint Group Germany GmbH, 70469 Stuttgart (DE)
(72) Erfinder: TELSER, Thomas, 69123 Heidelberg-Wieblingen (DE); BEYER, Matthias, 69469 Weinheim (DE); FLEISCHER, Daniel, 77866 Rheinau (DE)
(74) Vertreter: Schuck, Alexander
(86) Internationale Anmeldenummer: PCT/EP2016/081647
(87) Internationale Veröffentlichungsnummer: WO 2017/108649

(56) Entgegenhaltungen:
- EP-A1- 1 428 666
- EP-A1- 2 199 082
- WO-A1-2009/099417
- WO-A1-2012/074994
- US-A1- 2003 138 733

## Beschreibung

### Stand der Technik

Die Erfindung betrifft ein Verfahren zur Herstellung von Reliefdruckformen, beispielsweise von Flexodruckformen, wobei ein Träger mit einer polymeren Substratschicht bereitgestellt wird, eine Flüssigkeit enthaltend ein reaktives Monomer bildmäßig auf die polymere Substratschicht aufgebracht wird und anschließend die überschüssige Flüssigkeit von der Oberfläche entfernt wird und das entstandene Relief durch Vernetzung fixiert wird.

Reliefdruckformen wie beispielsweise Flexodruckformen werden beispielsweise zum Bedrucken verschiedenster Verpackungen mit niedrig viskosen Druckfarben verwendet. Als Druckfarben werden meist polare Druckfarben auf Wasser- oder Alkoholbasis verwendet. Aufgrund des Druckverfahrens werden Flexodruckformen benötigt, die weich, elastisch und beständig gegenüber polaren Flexodruckfarben sind.

Übliche Flexodruckplatten enthalten daher ein weichelastisches unpolares Bindemittel, meist Blockcopolymere auf Basis Styrol-Isopren oder Styrol-Butadien, in Kombination mit Monomeren, Weichmacher und einem oder mehreren Fotoinitiatoren (siehe beispielsweise US 4,323,636). Diese fotopolymerisierbare Schicht ist im Allgemeinen wenige Millimeter dick und befindet sich auf einem dimensionsstabilen Träger, meist einer PET-Folie. Das Relief wird durch Belichten mit UV Licht durch ein Filmnegativ erzeugt. Bei der Belichtung vernetzen die belichteten Bereiche, die unbelichteten Bereiche der Flexodruckplatte bleiben dagegen löslich und werden durch Auswaschen in einem geeigneten organischen Lösungsmittel entfernt.

Alternativ zur Filmbelichtung können Flexodruckplatten auch durch eine mittels Laser erzeugte Maske belichtet werden. Die dünne ablatierbare Maskenschicht befindet sich auf der fotopolymerisierbaren Schicht (siehe beispielsweise US 5,262,275). Durch bildmäßige Ablation wird eine Maske erzeugt, durch die anschließend mit UV-Licht belichtet wird.

Unabhängig davon, ob die UV-Belichtung der fotopolymerisierbaren Schicht durch einen Film oder durch eine mittels Laser erzeugte integrale Maske erfolgt, muss das Relief anschließend durch Auswaschen in geeigneten organischen Lösungsmitteln erzeugt werden (siehe beispielsweise EP 332 070).

Beim Auswaschen des Reliefs quellen auch die vernetzten Bereiche der Flexodruckplatte durch das Lösungsmittel an. Dieses Lösungsmittel muss in einem Trocknungsschritt wieder entfernt werden. Durch die Temperaturempfindlichkeit der PET-Trägerfolie kann die Trocknung der Flexodruckformen bei maximal 60°C durchgeführt werden. Die notwendigen Trocknungszeiten sind lang. Je nach Schichtdicke der Flexodruckplatte werden Trocknungszeiten von 30 Minuten bis zu mehreren Stunden benötigt.

Es hat daher nicht an Versuchen gefehlt, Flexodruckformen zu entwickeln, die schneller entwickelt werden können. Beispielsweise können Flexodruckplatten auch thermisch entwickelt werden (siehe beispielsweise EP 1 239 329 oder EP 1 170 121). Hierbei werden die Flexodruckplatten nach der bildmäßigen Belichtung bis zur Schmelzetemperatur erwärmt. Die unbelichteten Bereiche der Flexodruckplatte werden dadurch klebrig und werden dann durch Auflegen eines Vlies oder eines Gewebes abgezogen. Allerdings ist das Verfahren apparativ aufwändig, da mehrere Lagen nacheinander abgezogen werden müssen, um ein ausreichendes Relief zu erzeugen. Ferner ist die Auflösung der so hergestellten Flexodruckformen geringer als die Auflösung von in Lösungsmitteln ausgewaschenen Flexodruckformen.

Grundsätzlich wäre daher ein Verfahren wünschenswert, in dem das Relief nicht durch einen Entwicklungsschritt erzeugt, sondern generativ (d.h. reliefaufbauend) hergestellt wird. Hierdurch könnte die Herstellzeit einer Reliefdruckform erheblich verkürzt und vereinfacht werden. Ferner würde erheblich weniger Material benötigt und die Ökobilanz einer derart hergestellten Druckform wäre wesentlich verbessert.

Für den hochqualitativen Druck flexibler Verpackungen werden heute Flexodruckplatten in einer Stärke von 1,14mm (inklusive der 0,175mm starken Trägerfolie) verwendet. Die Druckformen haben eine Relieftiefe von 0,4 bis 0,7mm. Werden die Flexodruckplatten mit Lösungsmittel ausgewaschen, so können freistehende Elemente bis zu einer Feinheit von 200µm (freistehender Reliefpunkt) oder 100µm (freistehende Linie) auf einer Flexodruckform abgebildet werden.

Feinere Elemente könnten nur dann auf einer Flexodruckform abgebildet werden, wenn eine geringere Relieftiefe gewählt wird. In der DE 102012013532 wird ein Flexodruckverfahren beschrieben, das mit Relieftiefen von weniger als 250µm arbeitet. Der Vorteil dieses Verfahrens ist, dass die zu bedruckende Bahn besser geführt wird und es zu keinen motivbedingten mechanischen Schwingungen in der Druckmaschine kommt. Wichtig bei dem Verfahren ist, dass der Reliefgrund nicht mit Druckfarbe eingefärbt werden darf, ansonsten druckt er mit. Dies ist unter Produktionsbedingungen heute noch schwer zu realisieren. Eine weitere Schwierigkeit des Verfahrens ist die exakte Einstellung einer geringen Relieftiefe.

Üblicherweise wird die Relieftiefe durch Belichten der Flexodruckplatte von der Plattenrückseite eingestellt. Die Relieftiefe kann dadurch in einem Bereich von +/-50µm kontrolliert werden. Soll eine Relieftiefe von absolut 100µm eingestellt, reicht diese Genauigkeit nicht mehr aus. Auch hier hätte ein generatives Verfahren, bei dem das Relief durch Aufbau an Stelle von Auswaschen erzeugt wird, systemimmanente Vorteile.

Noch feinere druckende Elemente in der Größenordnung von nur wenigen µm werden für Spezialanwendungen wie den Druck von Leiterbahnen für Touch-Screen-Displays benötigt. Wünschenswert wäre es, diese feinen Strukturen auch im Flexodruck herstellen zu können. Dazu werden Flexodruckformen benötigt, die geringe Relieftiefen haben (<100µm) aber feine Details in einer Größenordnung von 5 bis 50µm sicher und reproduzierbar abbilden können (siehe beispielsweise WO 2014/209428).

Es besteht also ein Bedarf nach Flexodruckformen mit niedrigem Relief und hoher Auflösung, wobei das Relief vorzugsweise in einem generativen Verfahren erzeugt wird.

Bekannt sind verschiedene Methoden ein Druckrelief mittels Ink-jet schichtweise d.h. generativ aufzubauen (siehe beispielsweise EP0641648, US2004/0131778, EP2033778, WO2012/175525, WO2014/095361, US2008/0053326).

Das allgemeine Prinzip dieser Patentschriften ist es, eine reaktive Monomermischung, beispielsweise eine Monomer/Fotoinitiatormischung, mittels eines Tintenstrahldruckverfahrens bildmäßig auf ein geeignetes Substrat aufzutragen und möglichst umgehend mittels UV-Licht zu immobilisieren bzw. zu härten, so dass die aufgetragenen Tröpfchen nicht spreiten oder verfließen können. Das Relief wird aufgebaut, indem so mehrere Schichten nacheinander aufgetragen werden.

Eine Flexodruckform mittels eines Tintenstrahldruckverfahrens aufzubauen, hat jedoch entscheidende Nachteile. Über einen Tintenstrahldruckkopf können nur Flüssigkeiten mit niedriger Viskosität aufgebracht werden. Üblicherweise liegt die Grenzviskosität bei Viskositäten <15mPas. Es können daher nur relativ kleine Moleküle zur Formulierung der reaktiven Monomermischung verwendet werden. Diese Monomere sind nicht in der Lage, ein weichelastisches, beständiges Material zu bilden, wie es für Flexodruckformen benötigt wird. Da die reaktiven Monomere meist aus der Klasse der Acrylsäure- oder Methacrylsäureester ausgewählt sind, sind die aufgebauten Materialien entweder zu hart oder sie sind ausreichend weich, aber dann gegenüber den polaren Flexodruckfarben nicht beständig.

US 2008/0053326 beschreibt ein Verfahren mit dem elastische Prepolymere oder Polymere über ein Tintenstrahldruckverfahren aufgetragen und vernetzt werden und ein flexotypisches Reliefmaterial schichtweise aufgebaut wird. Die Materialien müssen erwärmt werden, so dass dünnflüssige Schmelzen entstehen, die über das Tintenstrahlverfahren aufgebracht werden können.

EP 1 552 922 umgeht das Viskositätsproblem dadurch, dass feste Partikel in einer Trägerflüssigkeit dispergiert werden und diese Dispersion dann in einem Tintenstrahldruckverfahren schichtweise aufgebracht wird. Die Trägerflüssigkeit muss bei diesem Verfahren aber wieder entfernt werden, was das Verfahren aufwändig macht.

US 6,641,772 beschreibt ein Stereolithographieverfahren, mit dem flexotypische Materialien aufgebaut werden können. Hierbei wird eine temperaturempfindliche Harzlösung oder Schmelze mit einem IR-Laser punktuell aufgeheizt und zu dreidimensionalen Gebilden thermisch gehärtet. Das Verfahren ist apparativ aufwändig.

### Beschreibung der Erfindung

Überraschenderweise wurde gefunden, dass Flexodruckformen mittels eines generativen Verfahrens hergestellt werden können, wobei
a) ein Träger mit einer polymeren Substratschicht und einer laserablatierbaren Maskenschicht bereitgestellt wird, wobei die polymere Substratschicht ein erstes Bindemittel enthält,
b) eine Maske mit Öffnungen, die Bildelementen entsprechen, durch bildmäßige Ablation der Maskenschicht mittels Laser erzeugt wird,
c) eine Flüssigkeit enthaltend ein reaktives Monomer flächig auf die von der Maske bedeckte polymere Substratschicht aufgebracht wird,
d) die Flüssigkeit bzw. das reaktive Monomer durch die Öffnungen der Maske in die polymere Substratschicht für eine definierte Einwirkungszeit eindiffundiert und so ein Relief ausbildet,
e) anschließend die überschüssige Flüssigkeit bzw. das überschüssige Monomer und gegebenenfalls die Maske von der Oberfläche entfernt werden, und
f) das entstandene Relief durch Vernetzung fixiert wird.

Der Kern der Erfindung ist, dass der reaktiven Flüssigkeit ausreichend Zeit gegeben wird, um durch die Öffnungen der ablatierten Maske in die polymere Substratschicht einzudiffundieren und das Relief zu bilden und das Relief anschließend durch Vernetzung fixiert wird. Die Auflösung der gebildeten Flexodruckform hängt dabei im Wesentlichen von der Dimension der Maskenöffnungen, der gewählten Diffusionszeit, der Diffusionsgeschwindigkeit der reaktiven Flüssigkeit in die polymere Substratschicht und vom Sperrverhalten der Maske gegenüber der reaktiven Flüssigkeit ab.

Die zum Ausbilden des Reliefs aufgetragene Flüssigkeit umfasst mindestens ein reaktives Monomer welches bei dem vorgeschlagenen Verfahren in die polymere Substratschicht eindiffundiert. Erst nachdem das reaktive Monomer durch die Substratschicht aufgenommen wurde erfolgt eine Aushärtung, durch die das reaktive Monomer immobilisiert wird. Nach der Aushärtung erfolgt keine weitere Diffusion des reaktiven Monomers in der Substratschicht. Durch das Eindringen des reaktiven Monomers in die polymere Substratschicht wird das Relief nicht auf der polymeren Substratschicht aufgebaut, sondern die polymere Substratschicht selbst wird aufgrund des eindiffundierten Materials angehoben und bildet das Relief aus. Im Gegensatz zu den Verfahren nach dem Stand der Technik ist das Material des Reliefs nicht alleine durch die aufgebrachte Flüssigkeit bzw. das reaktive Monomer vorgegeben, sondern das Relief wird durch eine Mischung aus dem Material der polymeren Substratschicht und dem reaktiven Monomer aufgebaut. Das Material des Reliefs ergibt sich somit aus der Kombination des in der Flüssigkeit enthaltenen reaktiven Monomers und dem Material der polymeren Substratschicht.

Das Auftragen der reaktiven Flüssigkeit kann beispielsweise durch flächiges Beschichten (Rakeln oder Sprühen) oder durch Eintauchen oder durch ein geeignetes Walzenauftragsverfahren erfolgen. Alternativ kann die mit der ablatierten Maske bedeckte Substratschicht auch auf eine Trommel montiert werden, die in die reaktive Flüssigkeit eintaucht und langsam rotiert, so dass ein gleichmäßiger Flüssigkeitsfilm auf die Oberfläche aufgetragen wird, oder die mit der ablatierten Maske bedeckte polymere Substratschicht wird durch ein Flüssigkeitsbad gezogen.

Die Höhe des gebildeten Reliefs hängt im Wesentlichen von der Diffusionsgeschwindigkeit des ausgewählten reaktiven Monomeren in der polymeren Substratschicht sowie von der gewählten Einwirkzeit und der Temperatur ab. Hierbei ist die Höhe des Reliefs abhängig vom Einsatzzweck der Druckform. Im Flexodruck werden Reliefdruckformen mit einer Relieftiefe im Bereich von 200 µm bis 3000 µm verwendet. Beim Druck flexibler Verpackungen beträgt die Relieftiefe üblicherweise 200 µm bis 700 µm. In anderen Anwendungen, beispielsweise im Elektronikbereich, bei dem leitfähige Strukturen auf einer Leiterplatte oder einem anderen Substrat erzeugt werden, werden Reliefdruckformen mit einer Relieftiefe im Bereich von 10 µm bis 100 µm benötigt.

Die polymere Substratschicht enthält ein erstes Bindemittel. Bevorzugt ist das mindestens eine reaktive Monomer im Verhältnis zum verwendeten Substratmaterial bzw. zum ersten Bindemittel derart ausgewählt, dass die Diffusionsgeschwindigkeit des reaktiven Monomers in dem ersten Bindemittel bei Raumtemperatur (22 °C) von 0,5 µm/min bis 100 µm/min bevorzugt in einem Bereich von 0,5 µm/min bis 10 µm/min liegt. Die Einwirkzeit liegt typischerweise im Bereich von 10 Sekunden bis zu 3600 Sekunden, so dass je nach Anwendung Reliefhöhen von 5 µm bis zu 500 µm erzeugt werden können.

Die Diffusionsgeschwindigkeit ist üblicherweise temperaturabhängig. Bevorzugt wird die gewünschte Diffusionsgeschwindigkeit des reaktiven Monomers in dem Material der polymeren Substratschicht bei der Temperatur erreicht, bei der der Auftrag der Flüssigkeit auf die Oberfläche der Substratschicht erfolgt. Beispielsweise erfolgt der Auftrag der Flüssigkeit bei einer Temperatur im Bereich von 20 °C bis 120°C. Die natürliche Obergrenze der Auftragstemperatur ist durch den Siedepunkt der Flüssigkeit bzw. des reaktiven Monomeren gegeben. Üblicherweise liegt die maximale Auftragstemperatur unter dem Siedepunkt des reaktiven Monomeren.

Eine weitere wesentliche Voraussetzung für das erfindungsgemäße Verfahren ist das Sperren der Maskenschicht gegenüber der ausgewählten reaktiven Flüssigkeit. Die Diffusionsgeschwindigkeit des reaktiven Monomeren in der Maskenschicht sollte um mindestens einen Faktor 3 bevorzugt um einen Faktor 5 niedriger liegen als die Diffusionsgeschwindigkeit des reaktiven Monomeren in der polymeren Substratschicht. Bevorzugt enthält die Maskenschicht ein zweites Bindemittel, welches im Verhältnis zum reaktiven Monomer derart ausgewählt ist, dass die Diffusionsgeschwindigkeit des reaktiven Monomers in dem zweiten Bindemittel bei Raumtemperatur (22 °C) um mindestens einen Faktor 3 bevorzugt um einen Faktor 5 niedriger liegt als die Diffusionsgeschwindigkeit des reaktiven Monomeren im ersten Bindemittel.

Die Maskenschicht befindet sich auf der polymeren Substratschicht. Während die Substratschicht eine Dicke von 0,1 mm bis zu mehreren Millimetern aufweisen kann, ist die Maskenschicht nur einige wenige µm dünn. Durch Ablation mittels eines geeigneten Lasers wird die Maske in situ auf der polymeren Substratschicht erzeugt. Die Auflösung der erzeugten Maske ist von der Auflösung des gewählten Lasers abhängig. Im Bereich der graphischen Industrie sind Auflösungen von 2500 dpi bis zu 5000 dpi im Bereich des Sicherheitsdrucks bis zu 10.000 dpi (dots per inch) üblich. Umgerechnet in einzelne Punktgrößen können bei einer gewählten Auflösung von 10.000dpi durch Laserablation einzelne Löcher mit einer Abmessung von 2,5 µm mal 2,5 µm in der Maske erzeugt werden.

Zur Ablation geeignete Laser können UV- oder VIS-Laser oder NIR- oder IR-Laser sein. Die Ablation der Maske kann flach erfolgen, wobei der gewählte Laser dann das Material zeilenförmig bearbeitet und ablatiert. Alternativ wird der Träger mit der polymeren Substratschicht, auf der sich die ablatierbare Maskenschicht befindet, auf die Trommel eines Trommellasers aufgebracht und rund bearbeitet. Die Laser können mehrere Laserstrahlen bzw. Strahlungsköpfe umfassen, so dass die Ablationszeit verringert wird. Als Lasertypen kommen CO₂-Laser, Neodym-Yag-Laser, Farbstofflaser, Faserlaser oder Diodenlaser in Frage.

Bei der Erzeugung der Maske werden in die ablatierbare Maskenschicht Öffnungen eingeschrieben, deren Form im Wesentlichen der Form der zu erzeugenden Bildelemente entspricht. Dabei werden durch den selektiven Abtrag der Maskenschicht Öffnungen in der Maskenschicht erzeugt. Durch diese Öffnungen gelangt die Flüssigkeit auf die polymere Substratschicht und erzeugt das Relief, so dass die erzeugten Reliefstrukturen ein Abbild der Öffnungen in der Maske darstellen.

Der Reliefaufbau erfolgt durch Eindiffusion der reaktiven Flüssigkeit bzw. des reaktiven Monomeren durch die Löcher der Maskenschicht in die polymere Substratschicht. Durch die hohe Auflösung der laserablatierbaren Maske ist das erfindungsgemäße Verfahren sehr gut geeignet, um feine Reliefstrukturen zu erzeugen.

Zur Erzeugung hochauflösender Reliefstrukturen bzw. Reliefelemente wie einzelner Punkte, Linien oder Buchstabenelemente kann das entsprechende Muster direkt in die laserablatierbare Maskenschicht eingeschrieben werden. Eine feine Linie der Breite 50 µm kann beispielsweise als Reliefelement aufgebaut werden, wenn in der Maske eine 50 µm Linie durch Ablation freigelasert wird. Die Höhe und die Form des durch Monomerdiffusion entstehenden Linienreliefs hängen dann wesentlich von der gewählten Einwirkungsdauer bzw. der Diffusionsgeschwindigkeit des gewählten Monomers in dem gewählten Substrat ab.

Ist die Einwirkungszeit so gewählt, dass die aufzubauende Reliefhöhe kleiner ist als die Linienbreite der Maske, dann wird die Diffusion des Monomeren bevorzugt in die Tiefe der polymeren Substratschicht erfolgen, und der Querschnitt der aufgebauten Relieflinie wird in erster Näherung rechteckig ausgebildet sein. Beispielsweise bedeutet das, dass bei entsprechend kurzer Einwirkzeit eine 5 µm hohe Linie der Breite 50 µm durch Monomerdiffusion aufgebaut werden kann und dass diese Relieflinie im Querschnitt in erster Näherung ein rechteckiges Profil aufweist. Da die Diffusion des Monomeren nicht nur in die Tiefe der polymeren Substratschicht sondern auch lateral erfolgt, wird die Linienbreite an der Oberfläche des Reliefs stets etwas geringer sein als die Breite der in der Maskenschicht freigelaserten Linie. Dieser Effekt kann dadurch berücksichtigt werden, dass, um eine 50 µm breite Relieflinie aufzubauen, die in der Maske freigelaserte Linienbreite um die Strecke der lateralen Diffusion größer gewählt wird. Will man eine Reliefhöhe von 5 µm aufbauen, ist die laterale Diffusion ebenfalls in der Größenordnung von 5 µm. Um eine 50 µm breite und 5 µm hohe Relieflinie aufzubauen, wird daher die Linienbreite der Maske bevorzugt um 10 µm (zweimal die laterale Diffusion) breiter angelegt, also eine 60 µm Linie freigelasert. Es ist somit bevorzugt, beim Einschreiben der Öffnungen in die Maskenschicht die Abmessungen der einzelnen Öffnungen, deren Form den zu erzeugenden Bildelementen im Wesentlichen entspricht, größer zu wählen als die Abmessungen der zu erzeugenden Bildelemente. Dabei werden die Abmessungen der Öffnungen um einen Betrag vergrößert, der der doppelten lateralen Diffusion des Monomeren entspricht. Als Abmessungen werden hier insbesondere der Durchmesser von Punkten sowie die Länge und Breite von Linien verstanden. Da die laterale Diffusion in erster Näherung der Reliefhöhe entspricht ist es bevorzugt, die Abmessungen um den doppelten Betrag der Reliefhöhe zu vergrößern.

Ist die Einwirkzeit so gewählt, dass eine Reliefhöhe in der Größenordnung der Linienbreite aufgebaut werden soll, dann wird die Diffusion des Monomeren gleichermaßen in die Tiefe der polymeren Substratschicht als auch lateral erfolgen. Das entstandene Linienrelief hat dann kein rechteckiges Profil mehr, sondern es weist abgerundete Kanten auf oder es entsteht ein Linienprofil, das in etwa einer Gaußschen Verteilungskurve entspricht.
Will man Reliefhöhen aufbauen, die größer sind als die laterale Dimension des Reliefelementes (beispielsweise eine 50 µm breite Linie, die 100 µm hoch sein soll), so stellt man fest, dass das ausgebildete Reliefelement wiederum stark verbreitert ist und auch nicht mehr die notwendige Reliefhöhe erreicht. Ursache ist wiederum die laterale Diffusion des Monomeren. Das Monomer verschwindet in die angrenzenden Nichtbildbereiche. Das ausgebildete feine Reliefelement erreicht daher nicht die Reliefhöhe, die ein größeres Reliefelement bei dem die laterale Diffusion vernachlässigt werden kann, aufweist.

Im Prinzip ist dieser Effekt drucktechnisch erwünscht. Der Fachmann spricht von einer Zurichtung der Höhe der Reliefelemente. Je feiner das Element, umso niedriger sollte das Relief sein, um im Druck gleiche Druckspannungen für alle Reliefelemente zu erreichen. Allerdings sollte eine Zurichtung maximal im Bereich von 10 µm liegen. Bei höheren Werten muss das Tieferliegen der feinen Reliefelemente kompensiert werden, um überhaupt ein gleichmäßiges Ausdrucken zu ermöglichen.

Um die feinen Reliefelemente auf gleiche Höhe wie größere Reliefelemente zu bringen, kann es erforderlich sein, die Umgebung des feinen Reliefelementes aufzurastern. Durch die Aufrasterung der Umgebung kann der Diffusionsfluss pro Flächeneinheit auf einen gewünschten Wert eingestellt werden und so beispielsweise ein gewünschter Reliefsockel um das Reliefelement herum aufgebaut werden oder eine Flanke eines Reliefelementes steiler oder flacher ausgebildet werden. Oder anders ausgedrückt: die Geschwindigkeit des Reliefaufbaus, ausgedrückt als gebildetes Relief in µm pro Einwirkzeit in Sekunden, kann durch die Anzahl der Löcher pro Flächeneinheit an jeder Stelle der Substratoberfläche gezielt eingestellt werden. Durch die Ausbildung eines Sockels um das feine Reliefelement herum wird der laterale Abfluss des Monomeren verringert und das feine Reliefelement weist eine Reliefhöhe auf, die der Reliefhöhe größerer Reliefelemente entspricht.

Dementsprechend ist es bevorzugt, beim Erzeugen der Maske in der Umgebung von Öffnungen die Durchlässigkeit der Maskenschicht für die Flüssigkeit zu erhöhen. Hierdurch wird zusätzlich zu dem Reliefelement, welches ein Abbild der Öffnung in der Maske ist, ein Sockel um das Reliefelement aufgebaut.

Die Umgebung einer Öffnung in der Maske kann durch eine Fläche definiert werden, die die Öffnung umgibt und durch eine Linie begrenzt wird, wobei der kleinste Abstand jedes Punktes der Linie zu der Öffnung fest vorgegeben wird. Die Form der Begrenzungslinie der Fläche entspricht somit der Form der Öffnung, jedoch ist die eingeschlossene Fläche gegenüber der Fläche der Öffnung vergrößert. Bevorzugt wird der Abstand der Begrenzungslinie zu der Öffnung im Bereich von 0,1 mm bis 5 mm, bevorzugt von 0,5 mm bis 1 mm, gewählt. Die Breite des so erzeugten Sockels entspricht im Wesentlichen dem Abstand der Begrenzungslinie zu der Öffnung.

Die Rasterung der Maskenschicht wird in der Umgebung einer Öffnung bevorzugt im Bereich von 20 bis 80 %, bevorzugt im Bereich von 40 bis 60% eingestellt, wobei 0% keiner Veränderung der Durchlässigkeit entspricht und 100% einer vollständigen Öffnung der Maskenschicht entspricht.

Beim Aufbau feiner Reliefelemente mit hoher Reliefhöhe können ferner spezielle Geometrieeffekte auftreten. Der Diffusionsfluss des Monomeren ist abhängig von der zur Verfügung stehenden Oberfläche. Eine sich während des Diffusionsprozesses bildende Reliefkante oder eine starke Reliefrundung bietet dem Monomeren eine höhere Einwirkungsfläche, so dass an der Kante oder der Rundung des Reliefelementes ein höherer Diffusionsfluss stattfindet als an der vormals ebenen Fläche. Als Folge hiervon können Reliefstrukturen mit deutlich ausgeprägten Kanten (der Fachmann spricht von cupping) entstehen. Auch diese Effekte können durch Aufrasterung der Reliefelemente selbst oder durch geeignete Aufrasterung der Umgebung kompensiert werden.

Eine Voraussetzung für die Verwendung der Aufrasterung ist, dass die gewählte Auflösung des Lasers und die Schärfe der einzelnen ablatierten Löcher in der Umgebung der Reliefelemente sehr viel feiner sind als die jeweiligen Reliefelemente. Die Löcher des erzeugten Punktrasters in der Umgebung der Öffnungen sollten mindestens um eine Größenordnung kleiner sein als die Öffnungen bzw. Reliefelemente selbst. Man wird den Laser zur Bebilderung der Maske daher mit einer hohen Auflösung von 5000 dpi oder ganz bevorzugt mit einer Auflösung von 10000 dpi betreiben.

Die Aufrasterung der Umgebung der Reliefelemente wird bevorzugt im FM-Verfahren (FM = frequenzmoduliert) durchgeführt. Dies bedeutet dass alle Löcher gleich groß gewählt werden und der unterschiedliche Diffusionsfluss durch die Anzahl der Löcher pro Flächenelement geregelt wird. Alternativ können die Löcher auch im AM-Verfahren (AM = amplitudenmoduliert) erzeugt werden, d.h. die Löcher werden unterschiedlich groß gewählt oder die Schichtdicke der Maskenschicht wird durch Laserung verringert, sofern die Maskenschicht noch eine geringe Durchlässigkeit für das eingesetzte Monomer hat. Durch eine lokale Verringerung der Schichtdicke der Maskenschicht wird an dieser Stelle die Durchlässigkeit für das Monomer erhöht.

Wählt man zur Aufrasterung das FM-Verfahren, dann sollten die ablatierten Löcher scharf begrenzt sein, gleichmäßige Durchmesser und bevorzugt scharfe Kanten aufweisen, um einen definierten Diffusionsfluss zu erzeugen. Die laserablatierbare Maskenschicht sollte daher eine hohe Laserempfindlichkeit aufweisen.

Eine weitere Voraussetzung für diese Variante des erfindungsgemäßen Verfahrens ist, dass die Maskenschicht während des Reliefaufbaus auf der sich bildenden Reliefoberfläche verbleibt. In den Flankenbereichen des entstehenden Reliefs wird die Maskenschicht dabei gedehnt. Die Maskenschicht sollte daher ausreichend flexibel sein. Sie darf während der Reliefausbildung nicht aufreißen, da ansonsten unkontrollierbare Diffusionseffekte stattfinden.

Nach der Einwirkzeit wird das überschüssige flüssige Monomer von der Oberfläche der Substratschicht entfernt. Wurde das Auftragen des Monomers mittels einer langsam rotierenden Trommel in einer Wanne durchgeführt, dann kann die Wanne abgesenkt werden und die Rotationsgeschwindigkeit erhöht werden, so dass das flüssige Monomer abgeschleudert wird. Bei dieser Verfahrensvariante verbleibt die Maske auf der Reliefform.

In einer bevorzugten Ausführungsform wird das überschüssige flüssige Monomer mittels eines geeigneten Lösungsmittels abgespült, wobei dieses Lösungsmittel die polymere Substratschicht nicht anquellen darf. Bevorzugt wird das Lösungsmittel so gewählt, dass mit dem flüssigen Monomer auch die Maskenschicht abgewaschen wird und nur die Reliefform zurückbleibt. Anschließend kann das anhaftende Lösungsmittel mittels Druckluft oder eines Luftrakels von der Oberfläche vollständig entfernt werden. Ein geeignetes Lösungsmittel ist beispielsweise eine Mischung aus einem Alkohol und Wasser, beispielsweise eine Mischung aus n-Propanol und Wasser mit einem Mischungsverhältnis von 1:1.

Nach dem Entfernen des überschüssigen Monomeren wird die Reliefform umgehend gehärtet. Da die Diffusionsvorgänge des Monomeren in der polymeren Substratschicht weiterlaufen, auch wenn das überschüssige Monomer entfernt wurde, und diese Diffusionsvorgänge die Abbildungsgenauigkeit beeinträchtigen, ist es empfehlenswert das Entfernen des Monomeren, das Abwaschen der Reste der Maskenschicht, sowie die Entfernung des Lösungsmittels möglichst rasch durchzuführen und dann auch umgehend den Härtungsdurchgang zu beginnen. Um reproduzierbare Ergebnisse zu erhalten, sollten die Verarbeitungszeiten exakt eingehalten werden. Hierbei werden insbesondere die vorgegebene Einwirkzeit, die zum Abspielen der Flüssigkeit erforderliche Zeit und die Zeit für den Härtungsdurchgang als Verarbeitungszeiten angesehen.

Bei dem Aushärten des Reliefs bildet das reaktive Monomer mit dem Polymer der Substratschicht ein dreidimensionales Netzwerk aus und eine weitere Diffusion des reaktiven Monomers in der Substratschicht wird gestoppt. Das Aushärten kann beispielsweise durch Einwirkung von Wärme oder Strahlung erfolgen. Bevorzugt wird die Substratschicht fotochemisch gehärtet. Das ganz besonders bevorzugte Härtungsverfahren ist die Fotopolymerisation. Hierzu werden reaktive Monomere in Kombination mit Fotoinitiatoren eingesetzt, die sich durch Einwirkung von elektromagnetischer Strahlung, insbesondere von ultraviolettem Licht aushärten lassen. Bevorzugt werden die Fotoinitiatoren hierbei nicht der Flüssigkeit zugegeben sondern sind bereits in der polymeren Substratschicht enthalten. Ultraviolettes Licht (UV-Licht) weist eine Wellenlänge im Bereich von 100 nm bis 400 nm auf. Besonders bevorzugt werden hierbei Fotoinitiatoren und reaktive Monomere eingesetzt, die sich durch Einwirkung von UV-A Strahlung aushärten lassen. UV-A Strahlung weist eine Wellenlänge im Bereich von 320 nm bis 400 nm auf. Zum Entkleben der Oberfläche der Reliefdruckplatte kann im Anschluss eine weitere Aushärtung mit UV-C Strahlung erfolgen. UV-C Strahlung weist eine Wellenlänge im Bereich von 100 bis 280 nm auf.

Zum Aushärten kann beispielsweise eine UV-Lichtquelle, insbesondere eine Lichtquelle mit Strahlung im UV-A Bereich, vorgesehen sein. Beispielsweise kann die UV-Lichtquelle als LED (light emitting diode)-Leiste ausgestaltet sein, die relativ zum Träger bewegt wird, um dessen gesamte Oberfläche zu überstreichen.

### Chemie der jeweiligen Schichten / Einsatzstoffe

Grundsätzlich kann das Verfahren mit jeder beliebigen polymeren Substratschicht realisiert werden. Allerdings bestehen zwischen dem ausgewählten Polymer der Substratschicht, der verwendeten reaktiven Flüssigkeit und dem Material der Maskenschicht bestimmte Abhängigkeiten, so dass nur bestimmte Kombinationen sinnvollerweise ausgewählt werden.

Das Polymer der Substratschicht wird man nach der Verwendung der Druckform auswählen. Will man zum Beispiel eine harte Buchdruckform aufbauen, die später mit viskosen UV-Farben oder ölbasierender Farbe verdruckt werden soll, dann wird man aus Gründen der Quellbeständigkeit, ein hartes, polares Polymer wie beispielsweise Polyvinylalkohol oder Polyamid auswählen. Um eine ausreichende Diffusionsgeschwindigkeit zu realisieren, wird man für die reaktive Flüssigkeit ein mit dem Polymer der Substratschicht verträgliches Monomer, d.h. ein polares Monomer beispielsweise ein Acrylat mit polaren OH- oder COOH-Funktionen auswählen. Umgekehrt wird man als Bindemittel der Maskenschicht dann ein unpolares Bindemittel auswählen, um die Sperrwirkung gegen das polare Monomer sicherzustellen.

Will man eine weichelastische Flexodruckform aufbauen, die mit polaren, niedrigviskosen Druckfarben auf Alkohol- oder Wasserbasis verdruckt wird, dann wird man wiederum aus Gründen der Quellbeständigkeit ein weichelastisches, unpolares Polymer als Bindemittel der Substratschicht auswählen. Um eine ausreichende Diffusionsgeschwindigkeit zu realisieren, wird man jetzt für die reaktive Flüssigkeit ein unpolares Monomer auswählen und als Polymer für die sperrende Maskenschicht auf ein polares Bindemittel zurückgreifen, um die Sperrwirkung gegen das unpolare Monomer sicherzustellen.

Im Folgenden werden Materialkombinationen beschrieben, die für den Aufbau einer weichelastischen Flexodruckform bevorzugt eingesetzt werden.

### Aufbau des Trägers

Der verwendete Träger ist bevorzugt als Verbundmaterial ausgebildet und umfasst
i) eine dimensionsstabile Trägerschicht in Form einer Trägerfolie oder einer dimensionsstabile Trägerhülse,
ii) die polymere Substratschicht,
iii) die laserablatierbare Maskenschicht und
iv) gegebenenfalls eine schützende Deckfolie.

Die dimensionsstabile Trägerschicht kann beispielsweise eine dimensionsstabile Trägerfolie wie eine Polyester-Folie oder ein Metallblech wie Aluminium oder Stahl sein. Beispiele für geeignete Materialien für die dimensionsstabile Trägerfolie sind Polyethylenterephthalat (PET), Polybutylenterephthalat (PBT), Polyethylennaphthalat (PEN) oder Polycarbonat (PC). Geeignet sind insbesondere PET-Folien in einer Stärke von 100µm bis 200 µm.

In einer Ausführungsform der Erfindung ist die Trägerschicht eine dimensionsstabile Trägerhülse bzw. Zylinderhülse. Gegebenenfalls können zwischen der dimensionsstabilen Trägerfolie, dem dimensionsstabilen Metallträger oder der dimensionsstabilen Zylinderhülse und der Substratschicht weitere Zwischenschichten angeordnet sein. Eine solche Zwischenschicht kann beispielsweise eine haftvermittelnde Schicht sein.

Handelt es sich bei der Reliefdruckform um ein Flexodruckelement mit einer zylindrischen Form (Sleeve), so kommen als dimensionsstabile Trägerhülse zylindrische Polyester-Hülsen, mit Glasfasern verstärkte Polyester-Hülsen oder andere runde Trägermaterialien wie Nickelhülsen in Frage. Diese zylindrischen Trägerhülsen weisen eine Dicke von 0,1 mm bis zu einigen wenigen mm auf.

Auf der dimensionsstabilen Trägerfolie oder Trägerhülse befindet sich die polymere Substratschicht, die als wesentliche Komponenten ein erstes polymeres Bindemittel, einen Fotoinitiator sowie weitere optionale Komponenten enthält.

Um die für den Flexodruck typischen weichelastischen Eigenschaften der Druckform zu erreichen, werden als Bindemittel der polymeren Substratschicht (erstes Bindemittel) bevorzugt weiche, elastomere Materialien eingesetzt.

Als weiche, elastomere Materialien kommen beispielsweise Polybutadien, Polyisopren, Copolymere aus Butadien und Styrol, Copolymere aus Isopren und Styrol, Styrol-Butadien-Blockcopolymere, Styrol-Isopren-Blockcopolymere, Styrol-Ethylen/Butylen-Blockcopolymere, Styrol/Isopren/Butadien/Styrol-Blockcopolymere, Ethylen-Propylen-Dien-Kautschuke, Silicon-Kautschuke, Naturkautschuke, Chloroprenkautschuke, Nitrilkautschuke, Polyisobutylen und weichelastische Polyurethane in Betracht.

Bevorzugt eingesetzt werden thermoplastisch verarbeitbare, elastomere Blockcopolymere. Die thermoplastisch-elastomeren Blockcopolymere umfassen mindestens einen Block, welcher im Wesentlichen aus Alkenylaromaten besteht und mindestens einen Block, welcher im Wesentlichen aus 1,3-Dienen besteht. Bei den Alkenylaromaten kann es sich beispielsweise um Styrol, α-Methylstyrol oder Vinyltoluol handeln. Bevorzugt handelt es sich um Styrol. Bei den 1,3-Dienen handelt es sich bevorzugt um Butadien und/oder Isopren. Bei diesen Blockcopolymeren kann es sich sowohl um lineare, verzweigte oder radiale Blockcopolymere handeln. Im Allgemeinen handelt es sich um Dreiblockcopolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymere eingesetzt werden. Handelsübliche Dreiblockcopolymere enthalten häufig gewisse Anteile an Zweiblockcopolymeren. Die Dien-Einheiten können 1,2- oder 1,4-verknüpft sein. Weiterhin einsetzbar sind auch thermoplastisch elastomere Blockcopolymere mit Endblöcken aus Styrol und einem statistischen Styrol-Butadien-Mittelblock. Selbstverständlich können auch Gemische mehrerer thermoplastisch-elastomerer Blockcopolymere eingesetzt werden.

Ferner können thermoplastisch verarbeitbare elastomere Blockcopolymere eingesetzt werden, die teilweise oder vollständig fluoriert sind oder in die fluorierte Seitenketten eingebaut sind. Diese Polymere verleihen der Substratschicht eine farbabstoßende Eigenschaft, die sich beim Druck mit niedrigem Relief - insbesondere bei Anwendungen im Elektronikbereich - vorteilhaft auswirkt.

Das thermoplastische elastomere Material der polymeren Substratschicht besteht bevorzugt überwiegend aus einem Polymer ausgewählt aus Poly(styrolbutadienstyrol) (SBS), Poly(styrolisoprenstyrol) (SIS), Poly(styrolisoprenbutadienstyrol) (SIBS), Ethylen-Propylen-Dien-Kautschuk (EPDM) und anderen SB-Blockcopolymeren. Gut geeignet sind auch Poly(styrol-butadien/styrol-styrol)-Blockcopolymere, die unter dem Handelsnamen Styroflex® kommerziell verfügbar sind.

Die Gesamtmenge an verwendeten Bindemittel bzw. Polymeren in der polymeren Substratschicht beträgt üblicherweise 50 bis 100 Gew.-% bezüglich der Summe aller Bestandteile der Substratschicht, bevorzugt 50 bis 90 Gew.-% und besonders bevorzugt 60 bis 85 Gew.-%.

In der Regel umfasst die polymere Substratschicht einen oder mehrere Fotoinitiatoren. Geeignete Fotoinitiatoren bzw. Fotoinitiatorsysteme umfassen Benzoin oder Benzoinderivate, wie Methylbenzoin oder Benzoinether, Benzilderivate, wie Benzilketale, Acylarylphosphinoxide, Acylarylphosphinsäureester, Mehrkernchinone oder Benzophenone. Die Menge an Fotoinitiator in der polymeren Substratschicht beträgt in der Regel 0,1 bis 10 Gew.-%, bevorzugt 1 bis 5 Gew.-% und besonders bevorzugt 1,5 bis 3 Gew.-%, bezogen auf die Menge (Gewicht) aller Bestandteile der Substratschicht.

Enthält das Material der polymeren Substratschicht einen Fotoinitiator, so ist es bevorzugt, wenn die das reaktive Monomer enthaltende Flüssigkeit frei von Fotoinitiatoren ist. Da das reaktive Monomer nach Aufbringen auf die Oberfläche der Substratschicht in diese eindiffundiert, und in der Substratschicht der Fotoinitiator bereits vorhanden ist, muss der Flüssigkeit kein Fotoinitiator zugesetzt werden. Durch den Verzicht auf einen Fotoinitiator in der Flüssigkeit kann diese einfacher und sicherer gehandhabt werden, da die Gefahr eines unerwünschten Aushärtens vor dem Aufbringen auf die Substratschicht reduziert wird.

Das verwendete Material für die polymere Substratschicht ist bevorzugt frei von reaktiven Monomeren oder enthält weniger als 10 Gew.-%, bevorzugt weniger als 5 Gew.-%, an reaktiven Monomeren. Da die reaktiven Monomere mit der Flüssigkeit in die polymere Substratschicht eindiffundieren, muss die polymere Substratschicht keine reaktiven Monomere enthalten. Ein möglichst geringer Gehalt an reaktiven Monomeren in der polymeren Substratschicht ist zudem vorteilhaft, da dann die Eigenschaften des erzeugten Reliefs im Wesentlichen durch das erste Bindemittel bzw. durch das Material der polymeren Substratschicht bestimmt werden.

Aus drucktechnischer Sicht kann es jedoch vorteilhaft sein, dass die polymere Substratschicht bereits eine geringe Menge an reaktivem Monomer, bevorzugt weniger als 10 Gew.-% und besonders bevorzugt weniger als 5 Gew.-% enthält. Nach Aufbau und Aushärtung des Reliefs werden dann nicht nur die gebildeten Reliefteile ausgehärtet sondern alle Bereiche der Reliefdruckform, so dass eine Reliefdruckform mit gleichmäßigen mechanischen Eigenschaften im Reliefgrund und in den erhabenen Reliefbereichen entsteht.

Die polymere Substratschicht kann optional einen oder mehrere Weichmacher enthalten. Beispiele für Weichmacher umfassen paraffinische, naphthenische oder aromatische Mineralöle, synthetische Oligomere oder Harze wie Oligostyrol, hochsiedende Ester, oligomere Styrol-Butadien-Copolymere, oligomere α-Methylstyrol/p-Methylstyrol-Copolymere, flüssige Oligobutadiene, flüssige Polyisoprene, insbesondere solche mit einem mittleren Molekulargewicht zwischen 500 und 5000 g/mol, oder flüssige oligomere Acrylnitril-Butadien-Copolymere oder oligomere Ethylen-Propylen-Dien-Copolymere. Bevorzugte Weichmacher umfassen Weissöl, Butadienöl und Paraffinöl.

Die Menge aller Weichmacher in der polymeren Substratschicht beträgt in der Regel 0 bis 50 Gew.-% und bevorzugt bei 5 bis 30 Gew.-%. Die Menge der Weichmacher richtet sich auch nach dem jeweiligen Bindemittelsystem. Bei Reliefdruckplatten auf Basis eines Styrol-Isopren-Bindemittelsystems haben sich Weichmachermengen von 1 bis 10 Gew.-% bewährt. Bei Reliefdruckplatten auf Basis eines Styrol-Butadien-Bindemittelsystems haben sich Weichmachermengen von 20 bis 40 Gew.-% bewährt.

Optional kann die polymere Substratschicht noch weitere Additive wie mineralische Füllstoffe, kompressible Zusatzstoffe, Pigmente oder Farbstoffe enthalten. Als Füllstoff gut geeignet sind beispielsweise Silikate oder Quarzmehle, die die Oberflächentopographie der Substratschicht verändern und die Farbübertragung im Druck beeinflussen können. Durch Zusatz von Mikrohohlkugeln kann die Kompressibilität der Substratschicht erhöht werden.

Die Menge an Füllstoffen liegt üblicherweise unter 50 Gew.-%, bevorzugt bei kleiner 20 Gew.-%, bezogen auf alle Komponenten der polymeren Substratschicht.

Ferner kann die polymere Substratschicht oberflächenaktive Substanzen wie beispielsweise Wachse, Silikonöle oder fluorierte Verbindungen enthalten. Wie oben beschrieben, kann es für Reliefdruckformen mit niedrigem Relief erforderlich sein, die Oberfläche der polymeren Substratschicht farbabstoßend zu machen. Dies gelingt durch Zusatz von oberflächenaktiven Substanzen, die an die Oberfläche der polymeren Substratschicht diffundieren und dort einen hydrophoben, d.h. farbabstoßenden Schutzfilm ausbilden können. Der Schutzfilm sollte sich bevorzugt erst nach Härtung der Reliefdruckform auf der Oberfläche der Substratschicht ausbilden, da ansonsten die Diffusion des Monomeren beeinträchtigt werden kann. Der Anteil an oberflächenaktiven Substanzen in der polymeren Substratschicht liegt üblicherweise bei weniger als 5 Gew.-%, bevorzugt bei weniger als 2 Gew.-%.

Die Dicke der polymeren Substratschicht richtet sich im Wesentlichen nach der jeweiligen Anwendung bzw. nach der angestrebten Reliefhöhe. Die Dicke der polymeren Substratschicht sollte im Allgemeinen höher sein als die angestrebte Reliefhöhe. Für Anwendungen im Elektronikbereich, in denen geringe Reliefhöhen benötigt werden, können polymere Substratschichten von 0,1 mm bis zu 1,0 mm Dicke zum Einsatz kommen. Für den typischen Flexodruck werden Reliefhöhen von 0,3 mm bis 3,0 mm benötigt. Die polymeren Substratschichten sollten dann entsprechend mindestens 0,5 mm bis 3,0 mm dick sein. Für den Druck auf Wellpappe können noch dickere Substratschichten, bis zu 6 mm Dicke, zum Einsatz kommen.

Die polymere Substratschicht wird entweder durch Gießen aus Lösung oder aus der Schmelze durch Extrudieren und Kalandrieren hergestellt. Für die erfindungsgemäßen Anwendungen ist die Konstanz der Schichtdicke der polymeren Substratschicht über der Beschichtungsbreite und der Beschichtungslänge von entscheidender Bedeutung. Die maximale Abweichung der Schichtdicke sollte bei Schichtdicken von kleiner 1 mm bei plus/minus 10 µm liegen. Bei Schichtdicken von 1 mm bis zu 3 mm sollte die Schichtdickenabweichung maximal plus/minus 15 µm betragen.

Auf der Oberfläche der polymeren Substratschicht befindet sich die laserablatierbare Maskenschicht. Die Maskenschicht soll mittels eines Lasers ablatierbar sein und gegen die zum Einsatz kommende reaktive Flüssigkeit bzw. das zum Einsatz kommende Monomer sperren, d.h. eine Diffusion des Monomeren durch die Maske hindurch soll nicht stattfinden.

Die laserablatierbare Maskenschicht besteht aus mindestens einem zweiten polymeren Bindemittel und mindestens einer Licht absorbierenden Komponente, wobei das zweite polymere Bindemittel gleichzeitig auch die Licht absorbierende Komponente sein kann.

Die Wahl des polymeren Bindemittels der Maskenschicht (zweites polymeres Bindemittel) hängt von der jeweiligen Anwendung der Druckform ab. Will man mit dem erfindungsgemäßen Verfahren weichelastische, unpolare Flexodruckformen herstellen, wird man als Bindemittel für die Maskenschicht ein polares Bindemittel auswählen, um so die Sperrwirkung gegenüber dem unpolaren Monomeren sicherzustellen.

Wird der Träger bei dem erfindungsgemäßen Verfahren zur Ablation auf einen Trommellaser montiert, dann muss die Maskenschicht ausreichend flexibel sein. Hierbei wird die Maskenschicht als ausreichend flexibel angesehen, wenn diese bei der Krümmung des Trägers auf der Trommel keine Risse zeigt und die Maskenschicht bei der Demontage des polymeren Trägers keine Wellen, Runzeln oder sonstige Oberflächenstrukturen zeigt.

Die Maskenschicht sollte gut ablatierbar sein. Bei dem Ablationsprozess sollten scharfkantige Strukturen entstehen. Insbesondere sollten um die ablatierten Löcher herum keine Schmelzränder oder Ablagerungen aus der Ablationsabluft zu finden sein.

Gut geeignete polare Bindemittel für die Maskenschicht sind beispielsweise Polyvinylalkohole, niedrig-, mittel- oder hochverseifte Polyvinylacetate, Polyvinylacetale wie beispielsweise Polyvinylbutyral, wasser- oder alkohollösliche Polyamide, alkohollösliche Polyurethane oder Polyester, Polyacrylsäure, Cellulose oder Cellulosederivate wie beispielsweise Hydroxypropylcellulose oder Hydroxyethylcellulose oder Nitrocellulose, Ethylen-Vinylalkohol-Copolymere, Polycyanoacrylate, Polyethylenoxid bzw. Polyethylenoxidcopolymere.

Besonders gut geeignet sind Polyvinylacetate mit einem mittleren Verseifungsgrad zwischen 50 und 90 mol%. Bei diesen Bindemitteln handelt es sich streng genommen um Copolymere aus Vinylacetat und Vinylalkoholeinheiten. Diese Bindemittel sind ausreichend polar, sperren gegenüber unpolaren Monomeren und besitzen eine gute Flexibilität und sind darüber hinaus gut ablatierbar. Natürlich können auch Gemische der genannten Bindemittel eingesetzt werden.

Die laserablatierbare Maskenschicht enthält das oder die Bindemittel in einem Anteil von 50 bis 99 Gew.-% bezogen auf alle Bestandteile der Maskenschicht.

Des Weiteren enthält die Maskenschicht eine lichtabsorbierende Komponente. Je nachdem, welcher Laser zur Ablation eingesetzt werden soll, enthält die Maskenschicht zusätzlich zum zweiten polymeren Bindemittel UV-Absorber oder UVabsorbierende Farbstoffe oder Pigmente (UV-Laser), VIS-Farbstoffe oder NIR-Farbstoffe oder NIR-Pigmente oder IR-Pigmente (VIS-, IR-Laser).

Bevorzugt werden als lichtabsorbierende Komponente Ruß, Graphit, Nanorußpartikel oder Kohlenstoffnanoröhren verwendet. Ruß als lichtabsorbierende Komponente hat den Vorteil, dass keine Migration aus der Maskenschicht in die darunter liegende polymere Substratschicht stattfindet.

Sofern die lichtabsorbierende Komponente nicht mit dem zweiten polymeren Bindemittel identisch ist kann der gewichtsmäßige Anteil der lichtabsorbierenden Komponente 1 Gew.-% bis 60 Gew.-% betragen. Die Menge richtet sich nach der Schichtdicke der Maskenschicht, die eine Dicke von 0,5 µm bis maximal 10 µm bevorzugt von 0,5 µm bis 3 µm aufweist. Bei Schichtdicken unter 0,5 µm ist es schwierig, eine homogene, dichte und sperrende Schicht herzustellen. Bei Schichtdicken oberhalb 10 µm werden zu hohe Ablationsenergien benötigt und die Ablationszeiten werden zu lange. Die Lichtabsorption der Maskenschicht im Bereich der Wellenlänge des zum Einsatz kommenden Lasers sollte > 10% betragen.

Die Maskenschicht kann optional noch weitere Komponenten wie Weichmacher, vernetzende Komponenten, Dispergierhilfsmittel, Verlaufshilfsmittel, Haftkomponenten oder oberflächenaktive Substanzen enthalten.

Auf der laserablatierbaren Maskenschicht befindet sich in der Regel noch eine schützende Deckfolie, die vor der Anwendung, d.h. vor der Laserung abgezogen wird. Gut geeignet sind wiederum PET-Folien in einer Stärke von bevorzugt 50 µm bis 150 µm. Um ein leichtes Abziehen der Deckfolie sicherzustellen, kann die Deckfolie mit einer Antihaftbeschichtung versehen sein oder es kann eine silikonisierte Deckfolie verwendet werden.

Zur Herstellung der laserablatierbaren Maskenschicht können alle für dünne Schichten gängigen Auftragsverfahren wie Sprühen, Rakeln oder Walzenauftragsverfahren eingesetzt werden. In einer bevorzugten Ausführungsform wird die Maskenschicht zunächst auf die Deckfolie aufgetragen und die beschichtete Deckfolie anschließend auf die polymere Substratschicht auflaminiert. Wird die polymere Substratschicht durch Schmelzextrusion mit anschließender Kalandrierung hergestellt, dann werden die Trägerfolie und die mit der Maskenschicht beschichtete Deckfolie über die Kalanderwalzen eingefahren und so haftfest mit der polymeren Substratschicht verbunden. Nach Abkühlung des Verbundes werden aus der Bahn einzelne Platten geschnitten.

Befindet sich die polymere Substratschicht auf einem zylinderförmigen Träger, dann wird die Maskenschicht entweder aufgesprüht oder im Rollercoating-Verfahren aufgetragen. In dieser Ausführungsvariante wird in der Regel keine Deckfolie eingesetzt.

Die bei dem erfindungsgemäßen Verfahren eingesetzte Flüssigkeit umfasst mindestens ein reaktives Monomer. Wie oben beschrieben können generell beliebige reaktive Monomere eingesetzt werden. Bevorzugt eingesetzt werden ethylenisch ungesättigte Verbindungen, die in Kombination mit Fotoinitiatoren durch Fotopolymerisation gehärtet werden können.
Bevorzugte Monomere weisen daher mindestens eine polymerisierbare, ethylenisch ungesättigte Doppelbindung auf. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure oder Allylverbindungen erwiesen. Ganz besonders bevorzugte Monomere sind Mono-, Di- und Triacrylate sowie -methacrylate.

Beispiele für geeignete Monomere sind Methylmethacrylat, Ethylacrylat, Propyl(meth)acrylat, Butyl(meth)acrylat, 2-Ethylhexylacrylat, Laurylacrylat, Butandioldi(meth)acrylat, Hexandioldi(meth)acrylat, Nonandioldi(meth)acrylat, Dodecandioldi(meth)acrylat, Trimethylolpropantri(meth)acrylat, Hydroxyethyl-(meth)acrylat, Ethylenglykol(meth)acrylat, Ethylenglykoldi(meth)acrylat, Tri- bzw. Tetraethylenglykol(meth)acrylate, Glycerindi(meth)acrylat, Propylenglykolmono- bzw. -di-(meth)acrylate, Trimethylolpropantri(meth)acrylat, Pentaerythritoltetra(meth)acrylat sowie Poly(ethylenoxid)acrylate bzw. -methacrylate oder Poly(propylenoxid)acrylate bzw. -methacrylate.

Weitere geeignete reaktive Monomere können sein Glycidyl(meth)acrylat, Phenylglycidether(meth)acrylat, Benzyl(meth)acrylat, Cyclohexyl(meth)acrylat, Isobornyl-(meth)acrylat, Dihydrodicyclopentadienyl(meth)acrylat, Limonen-(meth)acrylat, Hexen(meth)acrylat, Dimethylamino-ethyl(meth)acrylat und Bisphenol-A-Diglycidetherdi(meth)acrylat. Geeignet sind ferner Acrylamide bzw. Methacrylamide wie beispielsweise Hexamethylenbis(meth)acrylamid. Geeignete Fumarate sind beispielsweise Diethylfumarat, Dibutylfumarat, Dioctylfumarat. Geeignete Maleinsäurederivate sind beispielsweise Dibutylmaleinat, Dioctylmaleinat, Laurylmaleinimid.

Geeignet sind ferner Polyester(meth)acrylate, Polyether(meth)acrylate, Polyurethan(meth)acrylate, Polybutadien-(meth)acrylate, Polyisopren-(meth)acrylate. Die Acrylate bzw. Methacrylate können weitere funktionelle Gruppen wie beispielsweise Amidgruppen, Sulfonsäureestergruppen oder Sulfonsäureamidgruppen enthalten. Geeignet sind auch teilfluorierte oder vollständig fluorierte Acrylate oder Methacylate und Siliconacrylate. Selbstverständlich können auch Gemische mehrerer verschiedener Monomere eingesetzt werden.

Wie oben beschrieben hängt die Wahl des Monomeren entscheidend vom Material der polymeren Substratschicht ab. Sollen mit dem erfindungsgemäßen Verfahren unpolare, weichelastische Flexodruckformen aufgebaut werden, dann werden bevorzugt relativ unpolare Monomere wie Ethylhexylacrylat, Hexandioldiacrylat, Hexandioldimethacrylat, Dodecandioldiacrylat, Dodecandioldimethacrylat, Cyclohexylacrylat, Cyclohexylmethacrylat, Isobornylacrylat, Isobornylmethacrylat, Dihydrodicyclopentadienylacrylat bzw. -methacrylat sowie Siliconacrylate oder fluorierte Acrylate eingesetzt.

Sollen mit dem erfindungsgemäßen Verfahren polare, harte Buchdruckformen Buchdruckformen aufgebaut werden, dann werden bevorzugt polare Monomere wie Hydroxyethylacrylat, Ethylenglykolacrylat, Polyethylenglykolacrylat, Glycerinacrylat, Phenylglycidetheracrylat, Trimethylolpropantricrylat oder die entsprechenden Methacrylate eingesetzt.

Das mindestens eine reaktive Monomer ist in der Flüssigkeit bevorzugt in einem Anteil von 50 Gew.-% bis 100 Gew.-%, besonders bevorzugt in einem Anteil von 80 Gew.-% bis 100 Gew.-% enthalten. Ganz besonders bevorzugt enthält die reaktive Flüssigkeit mehr als 90 Gew.-% Monomer.

Optional kann die Flüssigkeit noch weitere Komponenten umfassen. Die weiteren Komponenten sind bevorzugt ausgewählt aus Fotoinitiatoren, Weichmachern, Emulgatoren, Diffusionshilfsmitteln, Lösungsmitteln und oberflächenaktiven Substanzen.

Bevorzugt enthält die reaktive Flüssigkeit keinen Fotoinitiator, da dieser bereits in der polymeren Substratschicht vorhanden ist. Optional kann die reaktive Flüssigkeit aber auch einen oder mehrere Fotoinitiatoren enthalten. Die Menge an Fotoinitiator in der Flüssigkeit kann 0 Gew.-% bis 10 Gew.-% betragen.

Die Erfindung betrifft zudem eine bebilderbare Reliefdruckform mit einem Träger, umfassend eine dimensionsstabile Trägerschicht, eine polymere Substratschicht und eine laserablatierbare Maskenschicht. Die polymere Substratschicht und die laserablatierbare Maskenschicht sind dabei so gewählt, dass die Diffusionsgeschwindigkeit eines reaktiven Monomeren in der laserablatierbaren Maskenschicht mindestens um den Faktor 3 niedriger ist als in der polymeren Substratschicht. Die erfindungsgemäße bebilderbare Reliefdruckform ist zur Verwendung mit dem beschriebenen Verfahren ausgebildet, so dass im Rahmen des Verfahrens beschriebene Merkmale auch für die Reliefdruckform offenbart sind.

Ein weiterer Aspekt besteht in der Bereitstellung einer Vorrichtung zur Herstellung von Reliefdruckformen. Bevorzugt ist die Vorrichtung zur Durchführung der hierin beschriebenen Verfahren ausgebildet und/oder eingerichtet. Dementsprechend gelten im Rahmen des Verfahrens beschriebene Merkmale entsprechend für die Vorrichtung und umgekehrt die im Rahmen der Vorrichtung beschriebenen Merkmale entsprechend für das Verfahren.

Zweckmäßigerweise umfasst die Vorrichtung zwei Einrichtungen, wobei eine erste Einrichtung für das Lasern der Maskenschicht verwendet wird und für die weiteren Verfahrensschritte eine zweiten Einrichtung eingesetzt wird. Zur bildmäßigen Laserung können als erste Einrichtung alle handelsüblichen Trommel- oder Flachbettlaser verwendet werden. Bevorzugt wird hierbei ein Laserbelichter mit einer Auflösung von mehr als 2540 dpi, besonders bevorzugt mit 5080 dpi, eingesetzt.

Für das Aufbringen der monomeren Flüssigkeit und das Entfernen der überschüssigen Flüssigkeit nach Ende des Diffusionsvorganges und das Abwaschen der Maske sowie die Fixierung des entstandenen Reliefs können für den jeweiligen Verfahrensschritt eingerichtete Einheiten verwendet werden, die in einer gemeinsamen Einrichtung integriert ausgeführt sind. Alternativ können eine oder mehrere der verwendeten Einheiten als getrennte Einrichtung ausgeführt werden. Da die Entfernung des überschüssigen Monomeren, das Abwaschen der Maske und die Fixierung des Reliefs mittels UVA-Licht möglichst schnell erfolgen sollen, empfiehlt es sich diese Verfahrensschritte in einer Einrichtung vorzunehmen, die alle erforderlichen Einheiten integriert.

Das erfindungsgemäße Verfahren wird in den nachstehenden Beispielen erläutert.

Kurze Beschreibung der Figuren
- Figur 1: zeigt eine Perthometermessung eines Reliefs mit zwei Linien und
- Figur 2: zeigt eine elektronenmikroskopische Aufnahme eines ausgebildeten Reliefs.

Die folgenden Einsatzstoffe wurden verwendet (alle %-Angaben in Gew.-%):
Quintac 3621C, radiales Styrol-Isopren-Styrol-Blockcopolymer mit 15% Styrol von Nippon Zeon.

BDK, Benzildimethylketal von BASF.

Weißöl Winog 70, paraffinisches Weißöl von Shell.

HDDA, Hexandioldiacrylat, HDMA2, Hexandioldimethacrylat, EHA, 2-Ethylhexylacrylat, Monomere von BASF.

Levanyl Schwarz A-SF, wässrige Rußdispersion von Lanxess.

Zonyl FSN, Verlaufshilfsmittel von DuPont.

### Beispiele

### Versuch 1

### Herstellung der polymeren Trägerschicht

In einem Doppelschneckenextruder vom Typ ZSK53 wurde eine Polymermischung bestehend aus 85 % Quintac 3621C, 5 % BDK und 10 % Weißöl Winog 70 aufgeschmolzen, homogenisiert und aus einer Breitschlitzdüse ausgetragen und anschließend zwischen zwei PET-Folien kalandriert. Als Deckfolie wurde eine 100 µm dicke, silikonisierte Mylar PET Folie verwendet. Als Trägerfolie wurde eine 125 µm dicke Melinex D 740 Trägerfolie eingesetzt, die zuvor mit einer 5 µm dünnen Haftlackschicht beschichtet worden war. Die Gesamtstärke des Verbundes aus Trägerfolie, polymerer Substratschicht und Deckfolie betrug 1,8 mm. Der Verbund wurde auf einem Vakuumsaugband abgezogen und nach dem Abkühlen zu einzelnen Platten zugeschnitten.

### Herstellung der laserablatierbaren Maskenschicht

Eine Beschichtungslösung aus 70 % Alcotex 72.5, 29,8 % Levanyl Schwarz A-SF und 0,02 % Zonyl FSN wurde in einem Lösungsmittelgemisch (Wasser /n-Propanol 3:1) mit einem Feststoffgehalt von 5 % hergestellt. Die Beschichtungslösung wurde auf eine 100 µm dicke Mylar-Folie aufgerakelt und getrocknet. Die hergestellte Maskenschicht hatte eine Trockenschichtdicke von 3µm.

Herstellung der polymeren Trägerschicht mit der laserablatierbaren Maskenschicht Von der polymeren Trägerschicht wurde die silikonisierte Mylarfolie abgezogen und die mit der laserablatierbaren Maskenschicht beschichtete Mylarfolie bei einer Laminiertemperatur von 120 °C auf die polymere Substratschicht auflaminiert. Nach Abkühlen des Verbundes wurde die Mylarfolie abgezogen, wobei die laserablatierbare Maskenschicht auf der polymeren Substratschicht verblieb.

### Bestimmung der Diffusionsgeschwindigkeit der Monomeren

Zur Bestimmung der Diffusionsgeschwindigkeit der verschiedenen Monomere in der polymeren Substratschicht wurde die laserablatierbare Maskenschicht von der polymeren Trägerschicht abgezogen. Auf die Oberfläche der polymeren Substratschicht wurde eine 0,5 mm starke Aluschablone aufgelegt und mit Gewichten fixiert. Die Schablone enthielt ausgestanzte Löcher mit einem Durchmesser von 1 mm, 3 mm und 10 mm. Das jeweilige Monomer wurde bei Raumtemperatur (22 °C) in die Löcher der Schablone eingefüllt und für eine definierte Einwirkungszeit auf der polymeren Substratschicht belassen. Danach wurde überschüssiges Monomer durch Abspülen mit n-Propanol entfernt und das entstandene Relief durch Belichtung mit UVA-Licht (10 Minuten, Röhrenbelichtung, nyloflex FIII Belichter von Flint Group) fixiert. Danach wurde die Oberfläche für weitere 3 Minuten mit UVC-Licht (nyloflex F III Belichter) bestrahlt, um die Oberfläche zu entkleben. Das entstandene Reliefplateau wurde anschließend mittels Perthometer vermessen.

Führt man das Experiment für verschiedene Einwirkzeiten (1 Minute, 10 Minuten, 20 Minuten, 60 Minuten) durch, so stellt man fest, dass die Höhe des gebildeten Reliefplateaus in erster Näherung linear mit der Einwirkzeit ansteigt. Aus der Steigung der Geraden kann eine Diffusionsgeschwindigkeit in µm pro Zeiteinheit für ein gegebenes Monomer/Substratpaar ermittelt werden. Für das beschriebene Substratmaterial wurden für HDDA, HDMA und EHA die Diffusionsgeschwindigkeiten ermittelt (siehe Tabelle 1). Es sei darauf hingewiesen, dass die so ermittelten Diffusionsgeschwindigkeiten nicht exakt den üblichen in der Wissenschaft definierten Diffusionsgeschwindigkeiten entsprechen. Vielmehr handelt es sich um eine empirisch ermittelte Diffusionsgeschwindigkeit, mit der der Aufbau eines Reliefs nach dem erfindungsgemäßen Verfahren vorhergesagt werden kann.

Zur Bestimmung der Sperrwirkung der laserablatierbaren Maskenschicht wurden die Versuche mit den drei ausgewählten Monomeren wiederholt, wobei jetzt die Aluminiumschablone auf den Verbund aus Trägerfolie, polymerer Substratschicht und laserablatierbarer Maskenschicht aufgelegt wurde. Im Rahmen der Messgenauigkeit konnte auch bei maximaler Einwirkungszeit (60 Minuten) keine Reliefausbildung beobachtet werden.

**Tabelle 1**

| Monomer | Diffusionsgeschwindigkeit in µm/min (polymere Substratschicht) | Diffusionsgeschwindigkeit in µm/min (laserablatierbare Maskenschicht) |
|---|---|---|
| HDDA | 0.7 | < 0,1 |
| HDMA | 1,3 | < 0,1 |
| EHA | 4,4 | < 0,1 |

### Bebilderung mittels IR-Laser

Der Verbund aus Trägerfolie, polymerer Substratschicht und laserablatierbarer Maskenschicht wurde auf der Trommel eines IR-Lasers (Thermoflex 20, Xeikon) fixiert und mit einer Leistung von 30 W bei einer Auflösung von 5080 dpi bebildert. Als Bildinformation wurden einzelne Linien unterschiedlicher Breite (20 µm, 40 µm, 60 µm, 80 µm, 100 µm und 500 µm) sowie eine 3 Punkt Schrift eingeschrieben.

### Reliefaufbau durch Diffusion

Die so bebilderte Platte wurde anschließend bei Raumtemperatur in eine Wanne mit einer reaktiven Monomermischung getaucht. Als Monomermischung wurde eine Lösung aus gleichen Teilen HDDA und HDMA verwendet. Nach einer Einwirkzeit von 1 Stunde wurde die Platte aus der Wanne genommen und mit einer 1:1 Mischung aus Wasser und n-Propanol abgespült. Hierbei wird überschüssiges Monomer von der Substratoberfläche entfernt und gleichzeitig die laserablatierbare Maskenschicht weggewaschen. Die feuchte Platte wurde anschließend vorsichtig mit Druckluft trocken geblasen und sofort auf einem Röhrenbelichter (nyloflex F III, Flint Group) 10 Minuten mit UVA-Licht belichtet, wobei das entstandene Relief fixiert wird. Zur Entklebung wird die Reliefdruckform anschließend noch 3 Minuten mit UVC Licht bestrahlt und so die Oberfläche entklebt.

### Auswertung der Reliefdruckform

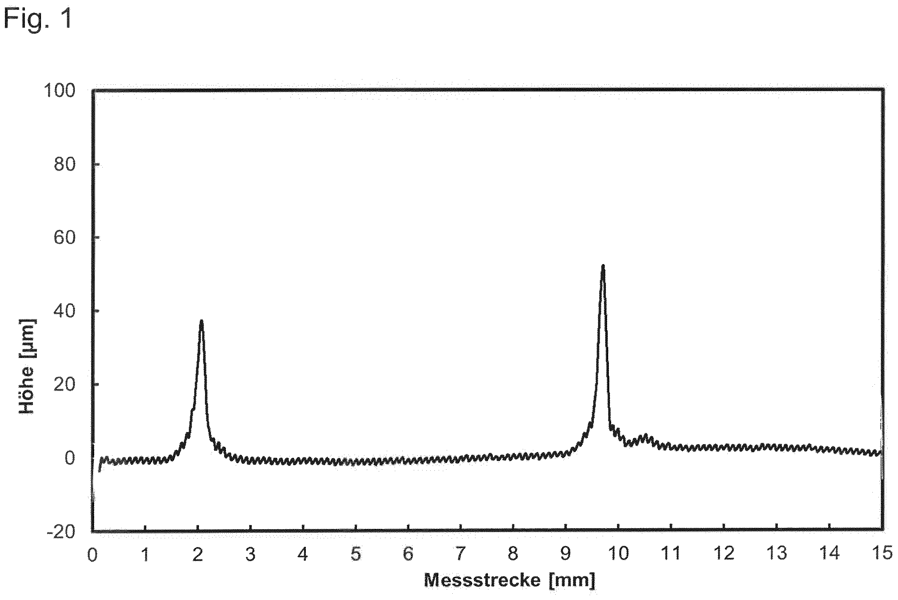

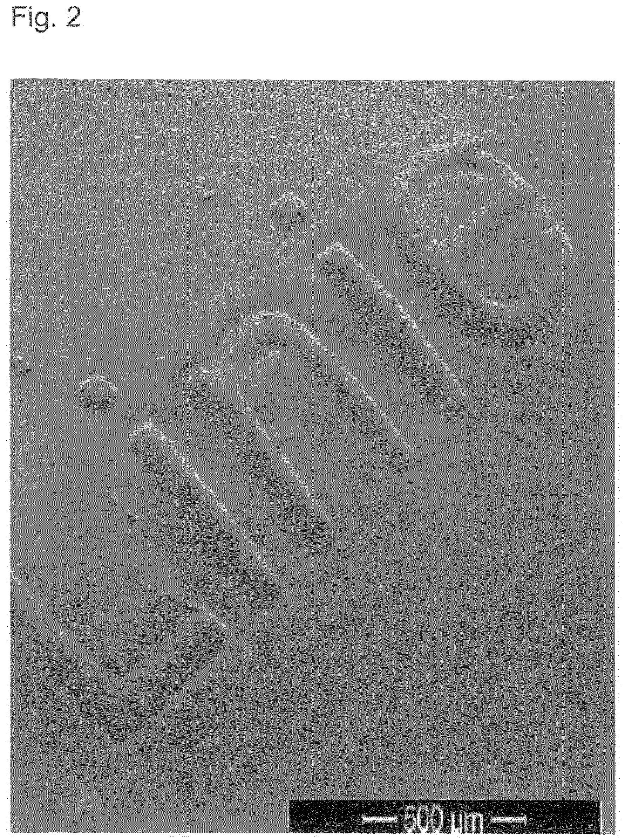

Die Reliefdruckform wurde anschließend mittels Perthometermessungen und elektronenmikroskopischer Aufnahmen ausgewertet. Figur 1 zeigt exemplarisch die Perthometermessung der scharf ausgebildeten 80 µm und 60 µm Linien. Figur 2 zeigt eine elektronenmikroskopische Aufnahme des ausgebildeten Schriftreliefs. Aus den Perthometerdiagrammen wurden die Reliefhöhen der jeweiligen Relieflinien ermittelt. Die Ergebnisse sind in Tabelle 2 zusammengefasst. Während das 500 µm breite Linienelement eine erwartete Reliefhöhe von 60 µm aufweist, erreichen die feineren Linienelemente auf Grund der lateralen Diffusion der Monomere die geforderte Reliefhöhe nicht. Die 20 µm Linie konnte mittels Perthometer nicht mehr vermessen werden.

### Versuch 2

Der Versuch wurde darauf wiederholt mit der Änderung, dass die Linienelemente auf beiden Seiten mit einem 0,5 mm breiten 50 % Rasterfeld umgeben wurden. Die Platte wurde wiederum mit einer Auflösung von 5080 dpi gelasert. Die einzelnen ablatierten Löcher in der Umgebung des Linienelementes hatten einen Durchmesser von 5 µm. Anschließend wurde wie bei Versuch 1 vorgegangen. Wiederum wurden die entstandenen Linienprofile mittels Perthometer ausgemessen. Wie erwartet waren die Linien jetzt auf einem 1mm breiten planen Sockel ausgebildet, der entsprechend des gerasterten Tonwerts von 50 % 30 µm hoch war. Die absolute Linienhöhe (Summe aus Sockelhöhe und Linienhöhe) erreichte bei allen Linienstärken jetzt die Sollhöhe von 60 µm +/- 10 µm.

**Tabelle 2**

| Breite Linienelement | Reliefhöhe ohne Sockel/ohne Umgebungsraster | Reliefhöhe mit Sockel/mit Umgebungsraster |
|---|---|---|
| 500 µm | 60 µm | 60 µm |
| 100 µm | 55 µm | 55 µm |
| 80 µm | 50 µm | 60 µm |
| 60 µm | 40 µm | 60 µm |
| 40 µm | 10 µm | 55 mm |
| 20 µm | < 10 µm | 50 µm |

Die so hergestellte Reliefdruckform wurde anschließend mittels eines kompressiblen Klebebands auf den Zylinder einer Flexodruckmaschine aufgeklebt und mit einer niedrigviskosen Flexofarbe verdruckt. Die Druckparameter sind in Tabelle 3 zusammengefasst.

**Tabelle 3**

| Druckmaschine | F&K FP 6S/8 |
|---|---|
| Substrat | PE-Folie |
| Druckfarbe | Siegwerk NC4012 Cyan |
| Viskosität Druckfarbe | 22 sec |
| Aniloxwalze | 460 L/cm, 3,5g/cm³ |
| Klebeband | Lohmann 5.3 |
| Druckqeschwindigkeit | 50 m/min |

Auf Grund der geringen Reliefhöhe wurde das Klischee ohne Überdruck, d.h. im sogenannten Kissprint, gedruckt. Alle Linienelemente konnten im Druck randscharf wiedergegeben werden. Die Versuche belegen, dass mittels des erfindungsgemäßen Verfahrens flexotypische Reliefdruckformen hergestellt werden können, die bei geringer Reliefhöhe hochaufgelöste Reliefstrukturen ermöglichen.

## Patentansprüche

1. Verfahren zur Herstellung von Reliefdruckformen mit den Schritten:
a) Bereitstellen eines Trägers mit einer polymeren Substratschicht und einer laserablatierbaren Maskenschicht, wobei die polymere Substratschicht ein erstes polymeres Bindemittel enthält,
b) Erzeugen einer Maske mit Öffnungen, die Bildelementen entsprechen, durch bildmäßige Ablation der Maskenschicht mittels eines Lasers,
c) flächiges Aufbringen einer Flüssigkeit enthaltend ein reaktives Monomer auf die Maske,
d) Eindiffundieren des reaktiven Monomers durch die Öffnungen der Maske in die polymere Substratschicht für eine vorgegebene Einwirkungszeit, wobei ein Relief ausbildet wird,
e) Entfernen von nicht eindiffundiertem Monomer von der Oberfläche, und
f) Fixieren des entstandenen Reliefs durch Vernetzung.

2. Verfahren nach Anspruch 1, **dadurch gekennzeichnet, dass** die polymere Substratschicht einen Fotoinitiator enthält.

3. Verfahren nach Anspruch 1 oder 2, **dadurch gekennzeichnet, dass** die Substratschicht frei von reaktivem Monomer ist oder weniger als 10 Gew.-% reaktives Monomer enthält.

4. Verfahren nach einem der Ansprüche 1 bis 3, **dadurch gekennzeichnet, dass** die laserablatierbare Maskenschicht ein zweites polymeres Bindemittel und eine lichtabsorbierende Komponente enthält, wobei die Diffusionsgeschwindigkeit des reaktiven Monomeren in dem zweiten polymeren Bindemittel bei Raumtemperatur kleiner ist als in dem ersten polymeren Bindemittel.

5. Verfahren nach Anspruch 4, **dadurch gekennzeichnet dass** das zweite Bindemittel ausgewählt ist aus Polyvinylalkohol, teil- oder hochverseiftem Polyvinylacetat, Polyvinylbutyral, Cellulose, Nitrocellulose, Polyethylenoxid-Polyvinylalkohol-Copolymeren, Polycyanoacrylat und Polyamid.

6. Verfahren nach einem der Ansprüche 4 bis 5, **dadurch gekennzeichnet, dass** die die lichtabsorbierende Komponente ausgewählt ist aus Ruß, Graphit, Nanorußpartikel und Kohlenstoffnanoröhren.

7. Verfahren nach einem der Ansprüche 1 bis 6, **dadurch gekennzeichnet, dass** das erste Bindemittel ausgewählt ist Styrol-Butadien-Styrol (SBS)-, Styrol-Isopren-Styrol (SIS)-, Styrol-Butadien/Styrol-Styrol-, Styrol-Isopren-Butadien-Styrol (SIBS)-, Styrol-Butadien (SB)-Blockcopolymeren, Ethylen-Propylen-Dien-Kautschuk (EPDM).

8. Verfahren nach einem der Ansprüche 1 bis 7, **dadurch gekennzeichnet, dass** das reaktive Monomer ausgewählt ist aus Ethylhexylacrylat, Hexandioldiacrylat, Dodecandioldiacrylat, Cyclohexylacrylat, Isobornylacrylat, Dihydrodicyclopentadienylacrylat und den entsprechenden Methacrylaten.

9. Verfahren nach einem der Ansprüche 1 bis 8, **dadurch gekennzeichnet, dass** die Flüssigkeit frei von Fotoinitiatoren ist.

10. Verfahren nach einem der Ansprüche 1 bis 9, **dadurch gekennzeichnet, dass** die Vernetzung des Reliefs gemäß Schritt f) durch Bestrahlen mit UV-Strahlung erfolgt.

11. Verfahren nach einem der Ansprüche 1 bis 10, **dadurch gekennzeichnet, dass** die Diffusionsgeschwindigkeit des reaktiven Monomeren in dem ersten polymeren Bindemittel bei Raumtemperatur mindestens 0,5 µm/Minute und maximal 10 µm/Minute beträgt.

12. Verfahren nach einem der Ansprüche 1 bis 11, wobei die Einwirkungszeit in Schritt c) 1 Minute bis 60 Minuten beträgt.

13. Verfahren nach einem der Ansprüche 1 bis 12, **dadurch gekennzeichnet, dass** das gebildete Relief eine Höhe von 5 µm bis 500 µm aufweist.

14. Verfahren nach einem der Ansprüche 1 bis 13, **dadurch gekennzeichnet, dass** beim Erzeugen der Maske gemäß Schritt b) die Abmessungen der Öffnungen größere Abmessungen aufweisen als die zu erzeugenden Reliefelemente.

15. Verfahren nach einem der Ansprüche 1 bis 14, **dadurch gekennzeichnet, dass** beim Erzeugen der Maske gemäß Schritt b) in einer Umgebung um die Öffnungen die Durchlässigkeit der Maske für die Flüssigkeit erhöht wird durch Einschreiben eines Punktrasters, wobei an den Punkten des Punktrasters weitere Öffnungen erzeugt werden.

16. Verfahren nach Anspruch 15, wobei das Punktraster eine Auflösung von mindestens 5000 dpi besitzt.

17. Verfahren gemäß den Ansprüchen 5, 7 und 8, **dadurch gekennzeichnet, dass** mit einer Mischung aus einem Alkohol und Wasser in Schritt e) das nicht eindiffundierte Monomer sowie die Maskenschicht abgespült werden.

18. Verfahren nach einem der Ansprüche 1 bis 17, **dadurch gekennzeichnet, dass** das Aufbringen der Flüssigkeit auf die Maske in Schritt c) durch Tauchen, Walzenauftrag, Aufsprühen oder Rakeln erfolgt.

## Claims

1. A method for the production of relief printing plates comprising the following steps:
a) provision of a support with a polymeric substrate layer and a laser-ablatable mask layer, wherein the polymeric substrate layer contains a first polymeric binder,
b) production of a mask with openings corresponding to pixels by imagewise laser ablation of the mask layer,
c) application of a liquid containing a reactive monomer over the surface of the mask,
d) diffusion of the reactive monomer through the openings of the mask into the polymeric substrate layer for a predetermined exposure time, wherein a relief is formed,
e) removal of non-diffused monomer from the surface, and
f) fixing of the resulting relief by cross-linking.

2. The method according to claim 1, **characterized in that** the polymeric substrate layer contains a photoinitiator.

3. The method according to claim 1 or 2, **characterized in that** the substrate layer is free of reactive monomer or contains less than 10 wt.% of reactive monomer.

4. The method according to one of claims 1 through 3, **characterized in that** the laser-ablatable mask layer contains a second polymeric binder and a light-absorbing component, wherein the diffusion rate of the reactive monomer in the second polymeric binder at room temperature is less than in the first polymeric binder.

5. The method according to claim 4, **characterized in that** the second binder is selected from polyvinyl alcohol, partially or highly saponified polyvinyl acetate, polyvinyl butyral, cellulose, nitrocellulose, polyethylene oxide-polyvinyl alcohol copolymers, polycyanoacrylate and polyamide.

6. The method according to one of claims 4 through 5, **characterized in that** the light-absorbing component is selected from carbon black, graphite, nanosized carbon black particles, and carbon nanotubes.

7. The method according to one of claims 1 through 6, **characterized in that** the first binder is selected from styrene-butadiene-styrene (SBS), styrene-isoprene-styrene (SIS), styrene-butadiene/styrene-styrene, styrene-isoprene-butadiene-styrene (SIBS), styrene-butadiene (SB) block copolymers, and ethylene propylene diene monomer (EPDM) rubber.

8. The method according to one of claims 1 through 7, **characterized in that** the reactive monomer is selected from ethylhexyl acrylate, hexanediol diacrylate, dodecanediol diacrylate, cyclohexyl acrylate, isobornyl acrylate, and the corresponding methacrylates.

9. The method according to one of claims 1 through 8, **characterized in that** the liquid is free of photoinitiators.

10. The method according to one of claims 1 through 9, **characterized in that** crosslinking of the relief according to step f) takes place by exposure to UV light.

11. The method according to one of claims 1 through 10, **characterized in that** the diffusion rate of the reactive monomer in the first polymeric binder at room temperature is at least 0.5 µm/minute and at most 10 µm/minute.

12. The method according to one of claims 1 through 11, wherein the exposure time in step c) is 1 minute to 60 minutes.

13. The method according to one of claims 1 through 12, **characterized in that** the relief formed has a height of 5 µm to 500 µm.

14. The method according to one of claims 1 through 13, **characterized in that** in producing the mask according to step b), the dimensions of the openings are greater than the relief elements to be produced.

15. The method according to one of claims 1 through 14, **characterized in that** in producing the mask according to step b), in an area around the openings, the permeability of the mask for the liquid is increased by writing in of a dot matrix, wherein further openings are produced at the dots of the dot matrix.

16. The method according to claim 15, wherein the dot matrix has a resolution of at least 5,000 dpi.

17. The method according to claims 5, 7 and 8, **characterized in that** the non-diffused monomer and the mask layer are rinsed off with a mixture of an alcohol and water in step e).

18. The method according to one of claims 1 through 17, **characterized in that** the application of the liquid to the mask in step c) takes place by immersion, roller application, spraying or doctoring.

## Revendications

1. Procédé de fabrication de plaques d'impression en relief, comprenant les étapes suivantes :
a) la préparation d'un support muni d'une couche de substrat polymère et d'une couche de masquage amovible par laser, la couche de substrat polymère contenant un premier liant polymère,
b) la formation d'un masque muni d'ouvertures, qui correspondent à des éléments d'image, par ablation selon l'image de la couche de masquage au moyen d'un laser,
c) l'application à plat d'un liquide contenant un monomère réactif sur le masque,
d) la diffusion du monomère réactif au travers des ouvertures du masque dans la couche de substrat polymère pendant un temps d'action prédéterminé, un relief étant ainsi formé,
e) l'élimination du monomère non diffusé de la surface, et
f) la fixation du relief formé par réticulation.

2. Procédé selon la revendication 1, **caractérisé en ce que** la couche de substrat polymère contient un photoinitiateur.

3. Procédé selon la revendication 1 ou 2, **caractérisé en ce que** la couche de substrat est exempte de monomère réactif, ou contient moins de 10 % en poids de monomère réactif.

4. Procédé selon l'une quelconque des revendications 1 à 3, **caractérisé en ce que** la couche de masquage amovible par laser contient un deuxième liant polymère et un composant absorbant la lumière, la vitesse de diffusion du monomère réactif dans le deuxième liant polymère à température ambiante étant inférieure à celle dans le premier liant polymère.

5. Procédé selon la revendication 4, **caractérisé en ce que** le deuxième liant est choisi parmi l'alcool polyvinylique, le polyacétate de vinyle partiellement ou hautement saponifié, le polyvinylbutyral, la cellulose, la nitrocellulose, les copolymères de polyoxyde d'éthylène-alcool polyvinylique, le polycyanoacrylate et le polyamide.

6. Procédé selon l'une quelconque des revendications 4 à 5, **caractérisé en ce que** le composant absorbant la lumière est choisi parmi le noir de carbone, le graphite, les nanoparticules de noir de carbone et les nanotubes de carbone.

7. Procédé selon l'une quelconque des revendications 1 à 6, **caractérisé en ce que** le premier liant est choisi parmi les copolymères séquencés de styrène-butadiène-styrène (SBS), de styrène-isoprène-styrène (SIS), de styrène-butadiène/styrène-styrène, de styrène-isoprène-butadiène-styrène (SIBS), de styrène-butadiène (SB), le caoutchouc d'éthylène-propylène-diène (EPDM).

8. Procédé selon l'une quelconque des revendications 1 à 7, **caractérisé en ce que** le monomère réactif est choisi parmi l'acrylate d'éthylhexyle, le diacrylate d'hexanediol, le diacrylate de dodécanediol, l'acrylate de cyclohexyle, l'acrylate d'isobornyle, l'acrylate de dihydrodicyclopentadiényle et les méthacrylates correspondants.

9. Procédé selon l'une quelconque des revendications 1 à 8, **caractérisé en ce que** le liquide est exempt de photoinitiateurs.

10. Procédé selon l'une quelconque des revendications 1 à 9, **caractérisé en ce que** la réticulation du relief selon l'étape f) a lieu par exposition à un rayonnement UV.

11. Procédé selon l'une quelconque des revendications 1 à 10, **caractérisé en ce que** la vitesse de diffusion du monomère réactif dans le premier liant polymère à température ambiante est d'au moins 0,5 µm/minute et d'au plus 10 µm/minute.

12. Procédé selon l'une quelconque des revendications 1 à 11, dans lequel le temps d'action à l'étape c) est de 1 minute à 60 minutes.

13. Procédé selon l'une quelconque des revendications 1 à 12, **caractérisé en ce que** le relief formé présente une hauteur de 5 µm à 500 µm.

14. Procédé selon l'une quelconque des revendications 1 à 13, **caractérisé en ce que** lors de la formation du masque selon l'étape b), les dimensions des ouvertures présentent des dimensions plus grandes que les éléments de relief à former.

15. Procédé selon l'une quelconque des revendications 1 à 14, **caractérisé en ce que** lors de la formation du masque selon l'étape b), la perméabilité du masque pour le liquide est augmentée dans un environnement autour des ouvertures par inscription d'une trame de points, des ouvertures supplémentaires étant formées au niveau des points de la trame de points.

16. Procédé selon la revendication 15, dans lequel la trame de points présente une résolution d'au moins 5 000 dpi.

17. Procédé selon les revendications 5, 7 et 8, **caractérisé en ce que** le monomère non diffusé et la couche de masquage sont rincés à l'étape e) avec un mélange d'un alcool et d'eau.

18. Procédé selon l'une quelconque des revendications 1 à 17, **caractérisé en ce que** l'application du liquide sur le masque à l'étape c) a lieu par immersion, application au rouleau, pulvérisation ou raclage.
